# EUROPÄISCHE PATENTSCHRIFT

(11) **EP 1 471 775 B1**
(45) Veröffentlichungstag und Bekanntmachung des Hinweises auf die Patenterteilung: **17.11.2010**
(21) Anmeldenummer: 04018028.3
(22) Anmeldetag: 24.07.2000
(51) Int. Cl.: H05B 33/14, H01L 33/00, C09K 11/80, C09K 11/78

(54) **Lichtquelle mit einer Leuchtstoffanordnung und Vergussmasse mit einer Leuchtstoffanordnung**
Light source with an arrangement of a luminescent substance and mouldable material with an arrangement of a luminescent substance
Source lumineuse avec un dispositif incluant une substance lumineuse et matière moulable contenant un arrangement d'une substance lumineuse

(30) Priorität: 23.07.1999 DE 19934126; 30.12.1999 DE 19963791
(43) Veröffentlichungstag der Anmeldung: 27.10.2004
(62) Teilanmeldung aus: 00960304.4
(73) Patentinhaber: OSRAM Opto Semiconductors GmbH, 93055 Regensburg (DE); Patent-Treuhand-Gesellschaft für elektrische Glühlampen mbH, 81543 München (DE)
(72) Erfinder: Debray, Alexandra, 91058 Erlangen (DE); Waitl, Günter, 93049 Regensburg (DE); Ellens, Andries, 81735 München (DE); Zwaschka, Franz, 85737 Ismaning (DE); Kummer, Franz, 80797 München (DE)
(74) Vertreter: Epping - Hermann - Fischer

(56) Entgegenhaltungen:
- EP-A- 0 142 931
- WO-A1-98/12757
- GB-A- 2 000 173

## Beschreibung

Die Erfindung betrifft eine Vergußmasse mit einer Leuchtstoffanordnung gemäß dem Patentanspruch 1.

Sie bezieht sich insbesondere auf eine gelb oder gelbgrün emittierende Granat-Leuchtstoffanordnung für die Anregung durch Wellenlängen im blauen oder im nahen UV-Spektralbereich. Als Vergußmasse ist insbesondere eine die Leuchtstoffanordnung enthaltende Gießharzmatrix und als Lichtquelle ist insbesondere eine lichtemittierende Diode (LED) in Verbindung mit der Leuchtstoffanordnung bzw. mit der Vergußmasse vorgesehen.

Aus der WO 98/05078 ist ein Leuchtstoff für Lichtquellen und eine zugehörige Lichtquelle bekannt. Als Leuchtstoff ist dort ein Granat mit der Struktur A₃B₅O₁₂:D eingesetzt, bei dem die erste Komponente aus mindestens einer von verschiedenen Seltenerdmetallen besteht, die Komponente B aus einem der Elemente Al, Ga oder In. Dotierstoff D ist Cer (Ce).

Aus der WO 97/50132 ist ein ähnlicher Leuchtstoff bekannt, bei dem als Dotierstoff entweder Ce oder Terbium (Tb) eingesetzt wird. Ce emittiert im gelben Spektralbereich, während Tb im grünen Spektralbereich emittiert. In beiden Fällen werden die Leuchtstoffe in Verbindung mit einer blau emittierenden Lichtquelle zu Erzielung einer weißen Mischfarbe verwendet. Aus der EP 0142931 und der GB 2000173 sind Leuchtstoffe mit Granatstruktur, aktiviert mit Ce und Tb bekannt.

Aus der WO 98/12757 ist eine wellenlängenkonvertierende Vergußmasse auf der Basis eines aus den vorgenannten Veröffentlichungen bekannten Leuchtstoffes und einer transparenten Vergußmatrix bekannt. Der Offenbarungsgehalt dieser Schrift wird hiermit durch Rückbezug aufgenommen.

Bei der Erzeugung von weißem Mischlicht, beispielsweise nach der WO 97/50132, deren Offenbarungsgehalt insbesondere in Bezug auf die Zusammensetzung des Vergusses und auf dessen Herstellung ebenfalls durch Rückbezug Inhalt dieser Beschreibung ist, ist es bekannt, die Farbtemperatur oder den Farbort des weißen Lichts durch geeignete Wahl, dh. Zusammensetzung des Leuchtstoffes, dessen Partikelgröße und dessen Konzentration zu variieren. Eine Optimierung des Farbtons (Farbort X und Y in der CIE-Farbtafel) des erzeugten weißen Lichts kann bei Zugrundelegung dieser Parameter jedoch nur mit vergleichsweise großem Aufwand optimiert werden. Dies gilt insbesondere für den sogenannten Unbuntpunkt oder "equal energy point", der bei den Koordinaten CIEX = 0,33 und CIEY = 0,33 liegt.

Weiterhin ist es aufwendig, den Leuchtstoff im Hinblick auf eine bessere Farbwiedergabe durch einen höheren Rotanteil im Spektrum zu optimieren.

Schließlich ist es schwierig, den Leuchtstoff hinsichtlich des Absorptionsmaximums des Leuchtstoffs bezogen auf den Spitzenwert der Emission des Lichtemitters hin zu optimieren.

Es ist demgemäß Aufgabe der vorliegenden Erfindung, eine Lichtquelle mit einer Leuchtstoffanordnung der eingangs genannten Art anzugeben, die sich schnell und einfach unter Zugrundelegung von Optimierungsparametern herstellen läßt und für eine zugehörige wellenlängenkonvertierende Vergußmasse sowie eine zugehörige Lichtquelle geeignet ist.

Die Erfindung löst diese Aufgabe durch die Merkmale des Patentanspruchs 1. Vorteilhafte Weiterbildungen und Ausgestaltungen der Erfindung sind in den abhängigen Ansprüchen angegeben.

Erfindungsgemäß wird, besonders bevorzugt für Lichtquellen, deren Emission im kurzwelligen optischen, insbesondere im blauen Spektralbereich oder im nahen UV-Spektralbereich liegen, eine Leuchtstoffanordnung mit mehreren Leuchtstoffen verwendet. Diese Leuchtstoffe besitzen vorzugsweise eine mit Cer dotierte Granatstruktur A₃B₅O₁₂, wobei die erste Komponente A wenigstens ein Element der aus Y, Lu, La, Gd, Sm und Tb bestehenden Gruppe enthält und die zweite Komponente B mindestens eines der Elemente Aluminium, Gallium oder Indium repräsentiert.

Die Herstellung und Wirkungsweise der beschriebenen Leuchtstoffe ist in den eingangs genannten Veröffentlichungen beschrieben. Hierbei ist insbesondere bemerkenswert, daß Terbium (Tb) bei einer Anregung im Spektralbereich zwischen etwa 400 und 500 nm als Bestandteil des Wirtsgitters, das heißt der ersten Komponente A des Granats, für einen gelb emittierenden Leuchtstoff geeignet ist, dessen Dotierstoff Cer ist. Terbium war zuvor neben Cer als Aktivator für die Emission im grünen Spektralbereich vorgeschlagen worden. Es ist möglich, Terbium als Hauptbestandteil der ersten Komponente A des Granats allein oder zusammen mit mindestens einem der weiteren oben vorgeschlagenen Seltenerdmetalle zu verwenden.

Besonders bevorzugt wird ein Granat der Struktur
(Tb_{1-x-y}SEₓCe_{y})₃(Al, Ga) ₅O₁₂ verwendet, wobei
SE = Y, Gd, La, Sm und/oder Lu;
0<=x<=0,5-y;
0<y<0,1 gilt.

Als zweite Komponente (B) wird mindestens eines der Elemente Al oder Ga verwendet. Die zweite Komponente B kann zusätzlich In enthalten. Der Aktivator ist Cer.
Diese Leuchtstoffe absorbieren elektromagnetische Strahlung mit einer Wellenlänge im Bereich zwischen 420nm bis 490nm und können deshalb für die Strahlung einer blauen Lichtquelle, insbesondere einer Halbleiter-LED, angeregt werden. LED-Halbleiterchips auf GaN-Basis oder auf InGaN-Basis sind vorzugsweise geeignet, die bei einem Emissionsmaximum im Bereich von 430 bis 480nm blaues Licht emittieren.

Unter Lumineszenzdiodenchip auf GaN- oder InGaN-Basis ist im Zusammenhang mit der vorliegenden Erfindung grundsätzlich ein Lumineszenzdiodenchip zu verstehen, dessen strahlungsemittierende Zone GaN, InGaN und/oder verwandte Nitride sowie darauf basierende Mischkristalle, wie beispielsweise Ga(Al,In)N, aufweist.

Derartige Lumineszenzdiodenchips sind beispielsweise aus Shuji Nakamura, Gerhard Fasol, The Blue Laser Diode, Springer Verlag Berlin Heidelberg 1997, S. 209ff bekannt.

Die zuvor beschriebenen Leuchtstoffe werden durch das blaue Licht angeregt und emittieren ihrerseits Licht, das wellenlängenverschoben im Bereich oberhalb 500nm liegt. Im Fall des Cer aktivierten Tb-Granat-Leuchtstoffs liegt das Maximum der Emission bei etwa 550nm.

Der oben angegebene Leuchtstoff absorbiert im Bereich 420 bis 490 nm und kann so durch die Strahlung einer blauen Lichtquelle angeregt werden. Gute Ergebnisse wurden mit einem blaues Licht emittierenden LED-Chip erzielt, dessen Emissionsmaximum bei 430 bis 470 nm liegt. Das Maximum der Emission des Tb-Granat:Ce-Leuchtstoffs liegt bei etwa 550 nm.

Dieser Leuchtstoff eignet sich besonders für die Verwendung in einem weißes Licht abstrahlenden LED-Bauelement, beruhend auf der Kombination eines blaues Licht aussendenden LED-Chips mit einem Leuchtstoffgemisch, das Tb-Granat-haltigen Leuchtstoff aufweist, der durch Absorption eines Teils der Emission des LED-Chips angeregt wird und dessen Emission die übrig bleibende Strahlung der LED zu weißem Licht ergänzt.

Als blaues Licht emittierender LED-Chip eignet sich insbesondere ein Ga(In)N-LED-Chip, aber auch jeder andere Weg zur Erzeugung einer blauen LED mit einer Emission im Bereich 420 bis 490 nm. Insbesondere wird als hauptsächlicher Emissionsbereich 430 bis 470 nm empfohlen, da dann die Effizienz am höchsten ist.

Durch die Wahl von Art und Menge an Seltenerdmetallen ist eine Feineinstellung der Lage der Absorptions- und der Emissionsbanden des Leuchtstoffgemischs möglich. In Verbindung mit Leuchtdioden eignet sich bei dem oben genannten Tb-Granat-Leuchtstoff vor allem ein Bereich für x, der zwischen 0,25 ≤ x ≤ 0,5-y liegt.

Der besonders bevorzugte Bereich von y liegt bei 0,02 < y < 0,06.

Gute Eignung als Leuchtstoff-Komponente zeigt ein Granat der Struktur
(TbₓSE_{1-x-y}Ce_{y})₃ (Al, Ga) ₅O₁₂,
wobei SE = Y, Gd, La und/oder Lu;
0 ≤ x ≤ 0,02, insbesondere x = 0,01;
0 < y < 0,1 gilt. Häufig liegt y im Bereich 0,01 bis 0,05.

Generell dienen kleinere Mengen an Tb im Wirtsgitter vor allem dazu, die Eigenschaften bekannter Cer-aktivierter Leuchtstoffe zu verbessern, während die Zugabe größerer Mengen an Tb gezielt vor allem dafür eingesetzt werden kann, die Wellenlänge der Emission bekannter Cer-aktivierter Leuchtstoffe zu verschieben. Daher eignet sich ein hoher Anteil Tb besonders gut für weiße LED mit niedriger Farbtemperatur unter 5000 K.

Es ist bekannt, blau emittierende LEDs auf Gallium-Nitrid- oder Indium-Gallium-Nidtrid-Basis mit Emissionsmaxima im Bereich zwischen 430 und 480nm zur Anregung eines Leuchtstoffs von Typ YAG:Ce, der in der Literatur ausführlich beschrieben ist, zu verwenden. Ein derartiger Leuchtstoff wird beispielsweise von der Firma Osram unter der Bezeichnung L175 vertrieben. Andere Leuchtstoffe sind bekannt, bei denen das Elemente Yttrium (Y) teilweise oder vollständig durch eines der oben angegebenen Seltenerdmetalle ersetzt ist.

Bei einem für das erfindungsgemäße Leuchtstoff-Gemisch geeigneten Leuchtstoff sind die Yttrium-Atome größtenteils durch Terbium ersetzt sind. Der Leuchtstoff kann beispielsweise die Zusammensetzung [Y_{0,29}Tb_{0,67}Ce_{0,04}]₃Al₅O₅ - nachfolgend als L175/Tb mit 67% Tb bezeichnet - haben.

Erfindungsgemäß ist vorgesehen, den Farbton und Farbort der Leuchtstoffanordnung durch Mischen von pigmentierten Leuchtstoffpulvern mit unterschiedlichen Zusammensetzungen und damit auch unterschiedlichen Absorptionsmaxima für das blaue Licht vorzusehen. Dies kann beispielsweise durch eine Mischung des Leuchtstoffs L175 (reines YAG:Ce) mit einem Leuchtstoff der beschriebenen Art, bei dem Yttrium teilweise oder vollständig durch Terbium ersetzt ist (L175/Tb,Tb > 0%), erfolgen. Das Mischungsverhältnis kann 1:1 sein. Es kann an Stelle von YAG:Ce jedoch auch ein anderer Leuchtstoff oder ein anderer aus diesem Leuchtstoff abgewandelter Leuchtstoff verwendet werden, wobei zusätzlich das Mischungsverhältnis variiert werden kann.

Ein besonderer Vorteil der Erfindung liegt darin, daß sich die Leuchtstoffe, die in Pulverform vorliegen, problemlos mischen lassen und damit auf vergleichsweise einfache Weise eine gezielte Einstellung des Zielfarbortes auf der CIE-Farbtafel ermöglichen. Auf der Farbtafel läßt sich somit ausgehend von einer Granatstruktur, wie reinem YAG:Ce, und dem Farbort der verwendeten LED ein Bündel von Geraden darstellen, von denen eine durch die ausgewählte Koordinate des Zielfarbortes geht. Durch die Kombination von LED-Chip und Leuchtstoffanordnung läßt sich die resultierende Farbortgerade der einzelnen Farborte in ihrer Neigung leicht variieren. So ist es ohne weiteres möglich, eine Lichtquellenanordnung mit einer LED und einem wellenlängenkonvertierenden Leuchtstoff zu erzeugen, dessen resultierende Farbortgerade exakt durch den Unbuntpunkt bei den Koordinaten X=0,33 und Y=0,33 auf der Farborttafel geht. Dieser Unbuntpunkt definiert reines Weiß. Darüber hinaus ist es möglich, eine Verschiebung des resultierenden Farbspektrums zu erreichen, beispielsweise hin zu einem höheren Rotanteil im Spektrum, was allgemein zu einer besseren Farbwiedergabe führt, beispielsweise durch höhere L175/Tb-Anteile.

Erfindungsgemäß ist weiterhin vorgesehen, eine Leuchtstoffanordnung gemäß der Erfindung in einer für die erzeugte Strahlung zumindest teilweise transparenten Vergußmasse, vorzugsweise in einem Kunststoff, besonders bevorzugt in einem Epoxid-, Silikon- oder Acrylat-Gießharz oder in einer Mischung solcher Harze, oder in einem anderen geeigneten strahlungsdurchlässigen Material, wie zum Beispiel anorganisches Glas, zu dispergieren. Dazu wird die erfindungsgemäße Leuchtstoffanordnung vorzugsweise als Pigmentpulvergemisch mit dem Gießharz und weiteren Elementen gemäß der in der WO98/12757 offenbarten Methode hergestellt.

Weiterhin ist gemäß der Erfindung eine zur Leuchtstoffanordnung gehörige Lichtquellenanordnung vorgesehen, bei der eine Strahlungsquelle Strahlung im blauen Bereich oder im UV-Bereich des optischen Spektrums emittiert und diese Strahlung teilweise oder vollständig mittels der erfindungsgemäßen Leuchtstoffanordnung in längerwellige Strahlung konvertiert wird, wobei bei teilweiser Konversion die konvertierte Strahlung mit der emittierten Strahlung der Strahlungsquelle zur Erzeugung weissen Mischlichts gemischt wird.

Eine derartige Lichtquellenanordnung mit allerdings nur einem Leuchtstoff ist ebenfalls aus der WO98/12757 bekannt.

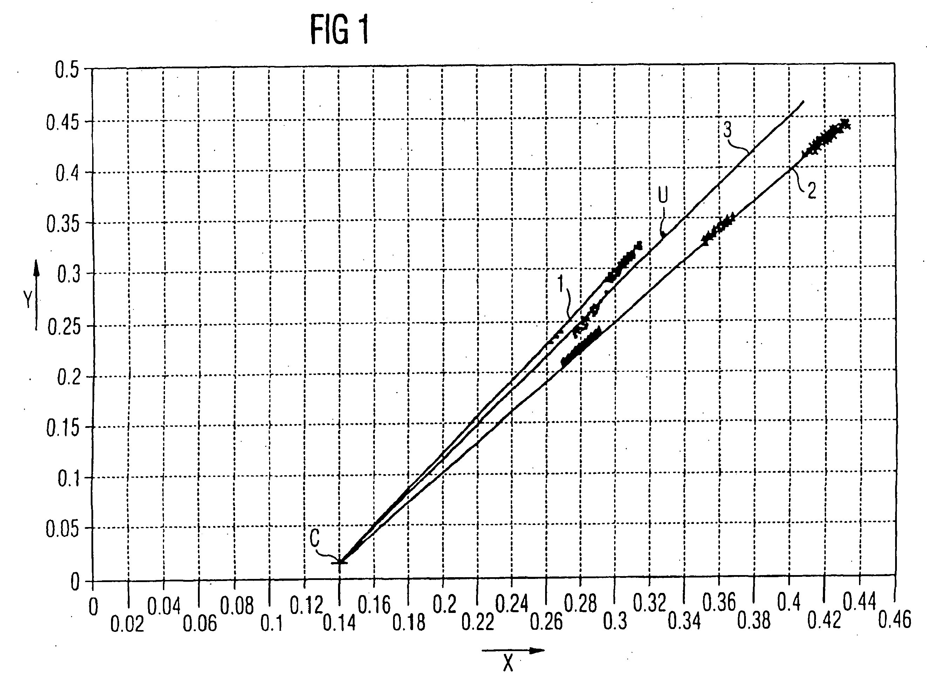

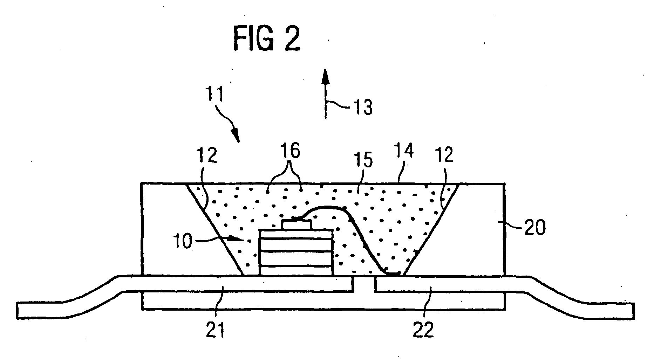

Die Erfindung wird nachfolgend anhand eines Ausführungsbeispieles in Verbindung mit den Figuren 1 und 2 der Zeichnung näher beschrieben. Es zeigen:
- Figur 1: ein Farbortdiagramm mit Farbortgeraden unterschied- licher Leuchtstoffe und der erfindungsgemäßen Leuchtstoffanordnung und
- Figur 2: eine schematische Schnittdarstellung durch das Aus- führungsbeispiel einer Lichtquellenanordnung gemäß der Erfindung.

Gemäß der Figur 1 ist ein Farbortdiagramm dargestellt, das auf der Abszisse die Farbortkoordinate X und auf der Ordinate die Farbortkoordinate Y der CIE-Farbtafel enthält.

Zugrundegelegt ist eine Lichtquellenanordnung zur Erzeugung weißen Mischlichts, wie sie beispielsweise in der WO97/50132 beschrieben ist.

Verwendet wird beispielsweise ein InGaN-basierter LED-Chip, der im blauen Spektralbereich emittiert und dessen Farbortpunkt C dementsprechend im Farbortdiagramm etwa bei X=0,14 und Y=0,02 liegt. Bei Mischung des blauen Lichts der LED mit dem Farbort C und des emittierten Lichtes eines beispielsweise in einem transparenten Gießharz eingebetteten Leuchtstoffes ergeben sich unterschiedliche Farbortgeraden.

Beispielsweise ergibt sich bei Verwendung von reinem YAG:Ce als Leuchtstoff eine Farbortgerade 1. Bei Verwendung eines Leuchtstoffs, bei dem Y teilweise oder überwiegend durch Terbium ersetzt ist, ergibt sich eine Farbortgerade, die unterhalb der Farbortgeraden 1 verläuft. Unter Verwendung eines Leuchtstoffes mit Tb-Gehalt auf dem A-Platz von 67% (gemäß der weiter oben angegebenen Formel), ergibt sich die im Diagramm eingezeichnete Farbortgerade 2.

Gerade 1 läuft oberhalb und Gerade 2 läuft unterhalb des Unbuntpunktes U, der bei den Farbortkoordinaten X=0,33 und Y=0,33 liegt. Bei einer Mischung der beiden Leuchtstoffe mit den Farbgeraden 1 und 2 im Verhältnis 1:1 und einer Einbettung in transparentes Gießharz (man vergleiche das weiter unten offenbarte Ausführungsbeispiel gemäß Figur 2) ergibt sich eine Farbortgerade 3 die, wie das Diagramm von Figur 1 zeigt, exakt durch den Unbuntpunkt oder Weißpunkt der Farborttafel geht.

In ähnlicher Weise ist es möglich, durch eine Mischung unterschiedlicher Leuchtstoffe vorzugsweise mit einer Granatstruktur, Farbortkurven durch verschiedene gewünschte Koordinaten der CIE-Farbtafel zu erhalten.

Das Leuchtstoffpulvergemisch ist vorteilhafterweise in ein entsprechend optimiertes Gießharz eingebettet, wobei insbesondere die Korngrößen des Leuchtstoffpulvers optimiert werden können. Verfahren zur Herstellung derartiger wellenkonvertierender Vergußmassen sind in der WO98/12757 beschrieben.

Bei der in Figur 2 schematisch dargestellten besonders bevorzugten Ausführungsform einer Lichtquellenanordnung ist ein GaN- oder InGaN-basierter Leuchtdiodenchip 10 in einer Ausnehmung 11 eines strahlungsundurchlässigen Leuchtdioden-Grundgehäuses 20, das vorzugsweise aus Kunststoff besteht, angeordnet.

Das Leuchtdioden-Grundgehäuse 20 ist von elektrischen Anschlußbahnen oder -beinchen 21,22 durchdrungen, über die die elektrischen Anschlüsse des Chips 10 aus dem Gehäuse herausgeführt sind.

Die Innenwände 12 der Ausnehmung 11 bilden einen Reflektor für das von dem Chip 10 ausgesandte Licht und für das von dem Leuchtstoffgemisch emittierte Licht und lenken dieses zur Hauptabstrahlrichtung 13 des Chips 10 hin um.

Die Ausnehmung 11 ist mit einer Vergussmasse 14 gefüllt, die eine transparente Gießharzmatrix 15, bevorzugt Epoxidgießharz oder Acrylatharz (z.B. Poymethylmetacrylat) oder eine Mischung dieser Harze aufweist, in die das vorgesehene Leuchtstoffpulvergemisch 16 eingebettet ist.

Das Leuchtstoffpulvergemisch enthält vorzugsweise Leuchtstoffpigmente mit Korngrößen ≤ 20µm und einen mittleren Korndurchmesser d₅₀ ≤ 5µm.

Neben Gießharz 15 und Leuchtstoffpigmenten 16 sind in der Vergußmasse 14 weiterhin vorzugsweise ein Thixotropiermittel, ein mineralischer Diffusor, ein Hydrophobiermittel und/oder ein Haftvermittler enthalten.

Bei dem Ausführungsbeispiel handelt es sich beispielsweise um ein weisses Licht emittierendes Leuchtdioden-Bauelement, bei dem in der Vergußmasse 14 die Farbstoffpulver L175 (YAG:Ce) und L175/Tb (mit 67% Tb) mit einem Mischungsverhältnis von 1:1 enthalten sind und dessen Farbort des emittierten Mischlichts auf der Geraden 3 des in Figur 1 dargestellten Diagramms liegt.

Es versteht sich, daß die Erläuterung der Erfindung anhand des oben beschriebenen Ausführungsbeispiels natürlich nicht als Beschränkung der Erfindung auf die beschriebenen Merkmale selbst anzusehen ist. Als Lichtquelle kommen neben Halbleiterkörpern aus Leuchtdioden-Chips oder Laserdioden-Chips insbesondere auch Polymer-LEDs in Betracht. Ebenso fallen in den Bereich der Erfindung auch Leuchtstoffpulver, die neben reinem YAG:Ce auch Anteile von Lu, La, Gd sowie Sm anstelle von Y besitzen. Weiterhin sind Granate einbezogen, bei denen der Terbium-Anteil kleiner ist als bei der oben beschriebenen Leuchtstofformel.

Die erfindungsgemäße Leuchtstoffanordnung und die zugehörige Vergußmasse ist grundsätzlich bei allen in der WO97/50132 und in der WO98/12757 offenbarten Bauformen von Leuchtdioden-Bauelementen verwendbar.

## Patentansprüche

1. Vergußmasse mit einer Leuchtstoffanordnung, die mehrere Leuchtstoffe enthält, mit mindestens einem mit Ce aktivierten Leuchtstoff mit Granatstruktur für die Anregung im Spektralbereich zwischen 400 nm und 500 nm
wobei
eine erste Komponente des Wirtsgitters der Granatstruktur wenigstens ein Element der aus Y, Lu, La, Gd, Sm und Tb bestehenden Gruppe enthält und zumindest teilweise durch Tb als Bestandteil des Wirtsgitters besetzt ist und
eine zweite Komponente des Wirtsgitters der Granatstruktur mindestens eines der Elemente Al, Ga oder In enthält.

2. Vergußmasse nach Anspruch 1, wobei Terbium alleine oder zusammen mit mindestens einem der Seltenerdmetalle Y, Lu, La, Gd und Sm ein Hauptbestandteil des Wirtsgitters der Cedotierten Granatstruktur ist.

3. Vergußmasse nach Anspruch 1 oder 2,
**dadurch gekennzeichnet,**
**daß** die Leuchtstoffpigmente Korngrößen ≤ 20µm und einen mittleren Korndurchmesser d₅₀ ≤ 5µm aufweisen.

4. Vergußmasse nach einem der Ansprüche 1 bis 3,
**dadurch gekennzeichnet,**
**daß** sie einen strahlungsdurchlässigen Kunststoff aufweist, in dem die Leuchtstoffe enthalten sind.

5. Vergußmasse nach Anspruch 4, wobei der Kunststoff ein Epoxid-Gießharz, ein Silikon-Gießharz, ein Acrylat-Gießharz oder eine Mischung dieser Gießharze ist.

6. Vergußmasse nach Anspruch 5, wobei die Leuchtstoffanordnung als anorganisches Leuchtstoffpigmentpulvergemisch mit dem Gießharz vermischt ist.

7. Vergußmasse nach einem der Ansprüche 5 oder 6,
**dadurch gekennzeichnet,**
**daß** sie Thixotropiermittel, ein mineralischer Diffusor, ein Hydrophobiermittel und/oder ein Haftvermittler enthält.

8. Vergußmasse nach einem der Ansprüche 1 bis 3, die ein anorganisches Glas aufweist, in dem die Leuchtstoffe enthalten sind.

9. Vergußmasse nach einem der Ansprüche 1 bis 8, bei der mindestens ein weiterer Leuchtstoff ein mit Ce aktivierter Leuchtstoff mit Granatstruktur für die Anregung im Spektralbereich zwischen 400 nm und 500 nm ist,
wobei
eine erste Komponente des Wirtsgitters der Granatstruktur wenigstens ein Element der aus Y, Lu, La, Gd, Sm und Tb bestehenden Gruppe enthält und zumindest teilweise durch Tb als Bestandteil des Wirtsgitters besetzt ist und
eine zweite Komponente des Wirtsgitters der Granatstruktur mindestens eines der Elemente Al, Ga oder In enthält.

10. Vergußmasse nach einem der Ansprüche 1 bis 9,
**dadurch gekennzeichnet,**
**daß** die Leuchtstoffanordnung einen Granat der Struktur (Tb_{1-x-y} SEₓCe_{y})₃(Al, Ga)₅O₁₂ enthält, wobei
SE = Y, Gd, La und/oder Lu;
0 ≤ x ≤ 0,5-y;
0 < y < 0,1 gilt

11. Vergußmasse nach einem der Ansprüche 1 bis 10, die einen Granat der Struktur Y₃(Al, Ga)₅O₁₂:Ce enthält.

## Claims

1. Potting compound comprising a luminescent material arrangement which comprises a plurality of luminescent materials including at least one Ce-activated luminescent material with garnet structure for excitation in the spectral range between 400 nm and 500 nm, wherein
a first component of the host lattice of the garnet structure comprises at least one element of the group consisting of Y, Lu, La, Gd, Sm and Tb, and is at least partly, occupied by Tb as a constituent of the host lattice, and
a second component of the host lattice of the garnet structure comprises at least one of the elements Al, Ga and In.

2. Potting compound according to Claim 1, wherein terbium, alone or together with at least one of the rare earth metals Y, Lu, La, Gd and Sm, is a main constituent of the host lattice of the Ce-doped garnet structure.

3. Potting compound according to Claim 1 or 2, **characterized in that**
the luminescent material pigments have grain sizes of ≤ 20 µm and an average particle diameter d₅₀ of ≤ 5 µm.

4. Potting compound according to any of Claims 1 to 3, **characterized in that**
it comprises a radiation-transmissive plastic in which the luminescent materials are contained.

5. Potting compound according to Claim 4, wherein the plastic is an epoxy casting resin, a silicone casting resin, an acrylate casting resin or a mixture of these casting resins.

6. Potting compound according to Claim 5, wherein the luminescent material arrangement is mixed with the casting resin in the form of an inorganic luminescent material pigment powder mixture.

7. Potting compound according to either of Claims 5 and 6, **characterized in that**
it comprises thixotropic agents, a mineral diffuser, a hydrophobing agent and/or an adhesion promoter.

8. Potting compound according to any of Claims 1 to 3, which comprises an inorganic glass in which the luminescent materials are contained.

9. Potting compound according to any of Claims 1 to 8, in which at least one further luminescent material is a Ce-activated luminescent material with garnet structure for excitation in the spectral range between 400 nm and 500 nm, wherein
a first component of the host lattice of the garnet structure comprises at least one element of the group consisting of Y, Lu, La, Gd, Sm and Tb, and is at least partly occupied by Tb as a constituent of the host lattice, and
a second component of the host lattice of the garnet structure comprises at least one of the elements Al, Ga or In.

10. Potting compound according to any of Claims 1 to 9, **characterized in that**
the luminescent material arrangement comprises a garnet of the (Tb_{1-x-y} SEₓCe_{y})₃(Al, Ga)₅O₁₂ structure where SE = Y, Gd, La and/or Lu;
0 ≤ x ≤ 0, 5-y;
0 < y < 0,1.

11. Potting compound according to any of Claims 1 to 10, which comprises a garnet of the structure Y₃(Al,Ga)₅O₁₂:Ce.

## Revendications

1. Masse de scellement, avec un dispositif à substance luminescente, qui contient plusieurs substances luminescentes, avec au moins une substance luminescente activée par du Ce, avec une structure de grenat pour l'excitation dans le domaine spectral compris entre 400 nm et 500 nm,
un premier constituant du réseau hôte de la structure de grenat contenant au moins un élément du groupe consistant dans Y, Lu, La, Gd, Sm et Tb et étant occupé au moins partiellement par Tb en tant qu'élément du réseau hôte et
un deuxième constituant du réseau hôte de la structure de grenat contenant au moins l'un des éléments Al, Ga ou In.

2. Masse de scellement selon la revendication 1, le terbium étant seul, ou conjointement avec au moins l'un des métaux des terres rares Y, Lu, La, Gd et Sm, un élément principal du réseau hôte de la structure de grenat dopée par du Ce.

3. Masse de scellement selon la revendication 1 ou 2, **caractérisée en ce que**,
les pigments de substance luminescente présentent des grosseurs de grains s 20 µm et un diamètre moyen de grain d₅₀ s 5 µm.

4. Masse de scellement selon l'une quelconque des revendications 1 à 3,
**caractérisée en ce**
**qu'**elle présente une matière plastique perméable au rayonnement, dans laquelle sont contenues les substances luminescentes.

5. Masse de scellement selon la revendication 4, la matière plastique étant une résine de coulée en époxyde, une résine de coulée en silicone, une résine de coulée en acrylate ou un mélange desdites résines de coulée.

6. Masse de scellement selon la revendication 5, le dispositif à substance luminescente étant mélangé avec la résine de coulée, en tant que mélange inorganique pulvérulent de pigments de substance luminescente.

7. Masse de scellement selon la revendication 5 ou 6,
**caractérisée en ce**
**qu'**elle contient des agents thixotropes, un diffuseur minéral, un agent donnant de l'hydrophobie et/ou un agent adhésif.

8. Masse de scellement selon l'une quelconque des revendications 1 à 3, qui comporte un verre inorganique, dans lequel les substances luminescentes sont contenues.

9. Masse de scellement selon l'une quelconque des revendications 1 à 8, dans laquelle au moins une
substance luminescente supplémentaire est une substance luminescente activée par du Ce avec une structure de grenat pour l'excitation dans le domaine spectral compris entre 400 nm et 500 nm,
un premier constituant du réseau hôte de la structure de grenat contenant au moins un élément du groupe consistant dans Y, Lu, La, Gd, Sm et Tb et étant occupé au moins partiellement par Tb en tant qu'élément du réseau hôte et
un deuxième constituant du réseau hôte de la structure de grenat contenant au moins l'un des éléments Al, Ga ou In.

10. Masse de scellement selon l'une quelconque des revendications 1 à 9,
**caractérisée en ce que**,
le dispositif de substance luminescente contient un grenat de la structure
(Tb_{1-x-y} SEₓCe_{y})₃ (Al, Ga)₅O₁₂, dans laquelle
SE = Y, Gd, La et/ou Lu;
0 ≤ x ≤ 0, 5-y ;
0 < y < 0,1.

11. Masse de scellement selon l'une quelconque des revendications 1 à 10, qui contient un grenat de la structure Y₃ (Al, Ga)₅O₁₂ : Ce.
